# EUROPEAN PATENT APPLICATION

(11) **EP 2 432 305 A1**
(43) Date of publication of application: **21.03.2012**
(21) Application number: 11189512.4
(22) Date of filing: 24.10.2006
(51) Int. Cl.: H05K 3/46, H05K 3/00

(54) **Flex-rigid wiring board and method of manufacturing the same**

(62) Divisional of application: 10186163.1
(71) Applicant: Ibiden Co., Ltd., Ogaki-shi Gifu 503-8604 (JP)
(72) Inventor: Takahashi, Michimasa, Gifu, 503-8503 (JP); Aoyama, Masakazu, Gifu, 503-8503 (JP)
(74) Representative: HOFFMANN EITLE

(57) **Abstract**

A flexible substrate 13 having conductor patterns 132 and 133, and a non-flexible substrate 111 with rigidity are disposed adjacent to each other in the horizontal direction. The flexible substrate. 13 and the non-flexible substrate 111. are covered with insulating layers 111 and 113 so that at least a portion of the flexible substrate is exposed. Vias 116 and 141 are formed in the insulating layers 111 and 116 so as to reach the conductor patterns 132 and 133 of the flexible substrate 13, and wirings 117 and 142 are formed by plating to reach the conductor patterns 132 and 133 through the vias 116 and 141. The insulating layers 114, 115, 144, and 145 are laminated on the insulating layers 111 and 113, and circuits 123 and 150 are formed for connection of wiring.

## Description

### Technical Field

The present invention relates to a flexible wiring board partially including a flex board and a method of manufacturing the same.

### Background Art

Flex-rigid wiring boards each including a rigid portion and a flexible portion are disclosed in, for example, Patent References 1 to 3.

A flex-rigid wiring board disclosed in Patent Reference 1 includes a core board provided as a rigid portion, a flexible board disposed adjacent to the core board in the horizontal direction, a flexible adhesive layer laminated on the core board and the flexible board, a wiring pattern formed on the flexible adhesive layer disposed in the rigid portion, and blind vias and/or through holes for connecting wiring patterns formed in respective layers.

In this constitution, the flexible adhesive layer is laminated on the flexible board, and thus bending stress of the flexible board is large. Therefore, large force is applied to a connection portion between a conductor of the flexible board and a conductor of the rigid board, thereby easily causing disconnection.

Patent Reference 2 discloses a method of manufacturing a flex-rigid wiring board. In the method, first, a rigid board having a vertical wiring portion formed in a connection region thereof and a flexible board having a connection terminal formed at an end thereof are separately formed. Then, the connection region of the rigid board is cut out to a depth larger than the thickness of the flexible board to form a step. Next, the connection terminal of the flexible board is connected to the vertical wiring portion of the step.

In the manufacturing method, connection between conductors of the rigid board and the flexible board becomes weak.

A flex-rigid wiring board disclosed in Patent Reference 3 includes a rigid board and a flexible board which are bonded together with an insulating adhesive to form a unified body. Furthermore, connection electrode pads of the rigid board and the flexible board are electrically and physically connected through bulk conductors provided through the insulating adhesive.

In the flex-rigid wiring board with the above-described constitution, the flexible board is disposed on one of the sides of the rigid substrate, and laser is applied to the flexible board side to form vias for plating connection. In this structure, a bending portion is maintained only on one side, and thus a portion connected by plating has low connection reliability.
Patent Reference 1: Unexamined Japanese Patent Application KOKAI Publication No. 2006-140213
Patent Reference 2: Unexamined Japanese Patent Application KOKAI Publication No. 2006-100703
Patent Reference 3: International Publication No. WO2004/093508

### Disclosure of Invention

### Problem to be Solved by the Invention

The present invention has been achieved in consideration of the above-described situation, and it is an object of the present invention to provide a flex-rigid wiring board with high reliability, particularly high connection reliability, and a method of manufacturing the same.
It is another object of the present invention to provide a flex-rigid wiring board which can be easily manufactured at low cost, and a method of manufacturing the same.

### Means for Solving the Problem

In order to achieve the objects, in a first aspect of the present invention, a flex-rigid wiring board includes a flexible substrate having a conductor pattern,
a non-flexible substrate disposed adjacent to the flexible substrate in the horizontal direction,
an insulating layer covering the flexible substrate and the non-flexible substrate to expose at least a portion of the flexible substrate,
and a conductor pattern formed on the insulating layer,
the conductor pattern of the flexible substrate being connected by plating to the conductor pattern on the insulating layer.

In order to achieve the objects, in a second aspect of the present invention, a flex-rigid wiring board includes
a flexible substrate having a conductor pattern,
a non-flexible substrate disposed adjacent to the flexible substrate in the horizontal direction,
and an insulating layer covering the flexible substrate and the non-flexible substrate to expose at least a portion of the flexible substrate,
wherein vias are formed in the insulating layer,
a conductor pattern is formed on the insulating layer, and the conductor pattern on the insulating layer is connected to the conductor pattern on the flexible substrate through the vias.

In order to achieve the objects, in a third aspect of the present invention, a flex-rigid wiring board includes
a flexible substrate having a conductor pattern and a protective layer covering the conductor pattern,
a non-flexible substrate, disposed adjacent to the flexible substrate in the horizontal direction,
an insulating layer covering the flexible substrate and the non-flexible substrate to expose at least a portion of the flexible substrate,
and a conductor pattern formed on the insulating layer, the conductor pattern of the flexible substrate being connected by plating to the conductor pattern on the insulating layer through vias formed in the insulating layer.

In order to achieve the objects, in a fourth aspect of the present invention, a method of manufacturing a flex-rigid wiring board includes
disposing a flexible substrate having a conductor pattern and a non-flexible substrate adjacent to each other,
covering the boundary between the flexible substrate and the non-flexible substrate with an insulating layer having a conductor pattern,
forming vias which pass through the insulating layer and reach the conductor pattern of the flexible substrate,
and connecting by plating the conductor pattern of the flexible substrate to the conductor pattern on the insulating layer through the vias.

### Effect of the Invention

According to the invention, an insulating layer covers a flexible substrate, thereby defining a conductor pattern of the flexible substrate and a conductor pattern on the insulating layer. Therefore, high connection reliability between the conductor pattern of the flexible substrate and the conductor pattern on the insulating layer can be achieved.

### Brief Description of Drawings

[Fig. 1A] Fig. 1A is a side view of a flex-rigid wiring board according to an embodiment of the present invention.
[Fig. 1B] Fig. 1B is a plan view of a flex-rigid wiring board according to an embodiment of the present invention.
[Fig. 2] Fig. 2 is a partially enlarged view of Fig. 1A.
[Fig. 3] Fig. 3 is a view showing a modified example of the flex-rigid wiring board shown in Fig. 2.
[Fig. 4] Fig. 4 is a side view of a flexible board.
[Fig. 5A] Fig. 5A is a view illustrating steps of a method of manufacturing a flex-rigid wiring board according to an embodiment of the invention.
[Fig. 5B] Fig. 5B is a view illustrating steps of a method of manufacturing a flex-rigid wiring board according to an embodiment of the invention.
[Fig. 5C] Fig. 5C is a view illustrating steps of a method of manufacturing a flex-rigid wiring board according to an embodiment of the invention.
[Fig. 5D] Fig. 5D is a view illustrating steps of a method of manufacturing a flex-rigid wiring board according to an embodiment of the invention.
[Fig. 5E] Fig. 5E is a view illustrating steps of a method of manufacturing a flex-rigid wiring board according to an embodiment of the invention.
[Fig. 5F] Fig. 5F is a view illustrating steps of a method of manufacturing a flex-rigid wiring board according to an embodiment of the invention.
[Fig. 5G] Fig. 5G is a view illustrating steps of a method of manufacturing a flex-rigid wiring board according to an embodiment of the invention.
[Fig. 5H] Fig. 5H is a view illustrating steps of a method of manufacturing a flex-rigid wiring board according to an embodiment of the invention.
[Fig. 5I] Fig. 5I is a view illustrating steps of a method of manufacturing a flex-rigid wiring board according to an embodiment of the invention.
[Fig. 5J] Fig. 5J is a view illustrating steps of a method of manufacturing a flex-rigid wiring board according to an embodiment of the invention.
[Fig. 5K] Fig. 5K is a view illustrating steps of a method of manufacturing a flex-rigid wiring board according to an embodiment of the invention.
[Fig. 5L] Fig. 5L is a view illustrating steps of a method of manufacturing a flex-rigid wiring board according to an embodiment of the invention.
[Fig. 6A] Fig. 6A is an enlarged view illustrating the method of manufacturing a flex-rigid wiring board shown in Figs. 5A to 5L.
[Fig. 6B] Fig. 6B is an enlarged view illustrating the method of manufacturing a flex-rigid wiring board shown in Figs. 5A to 5L.
[Fig. 6C] Fig. 6C is an enlarged view illustrating the method of manufacturing a flex-rigid wiring board shown in Figs. 5A to 5L.
[Fig. 6D] Fig. 6D is an enlarged view illustrating the method of manufacturing a flex-rigid wiring board shown in Figs. 5A to 5L.
[Fig. 6E] Fig. 6E is an enlarged view illustrating the method of manufacturing a flex-rigid wiring board shown in Figs. 5A to 5L.
[Fig. 6F] Fig. 6F is an enlarged view illustrating the method of manufacturing a flex-rigid wiring board shown in Figs. 5A to 5L.
[Fig. 7] Fig. 7 is a view showing a modified example of the flex-rigid wiring board shown in Fig. 2.
[Fig. 8] Fig. 8 is a view showing a modified example of the flex-rigid wiring board shown in Fig. 2.
[Fig. 9] Fig. 9 is a view showing an example of fan-out of a wiring pattern.
[Fig. 10] Fig. 10 is a view showing an example in which a flexible substrate is partially widened to increase strength.
[Fig. 11] Fig. 11 is a view showing an example in which a flexible substrate is partially widened to increase strength.

### Explanation of Reference Numerals

- 11, 12: rigid board
- 13: flexible board
- 131: substrate
- 132, 133: conductor layer
- 134, 135: insulating layer
- 136, 137: shield layer
- 138, 139: cover lay
- 111, 113: insulating layer
- 112: non-flexible substrate
- 114, 115, 144, 145: upper insulating layer
- 116, 119, 121, 141, 146, 147: via
- 117, 142: wiring pattern
- 118, 143: extraction pattern
- 120, 122: conductor
- 125: resin

### Best Mode for Carrying Out the Invention

A flex-rigid wiring board 10 according to an embodiment of the present invention will be described.

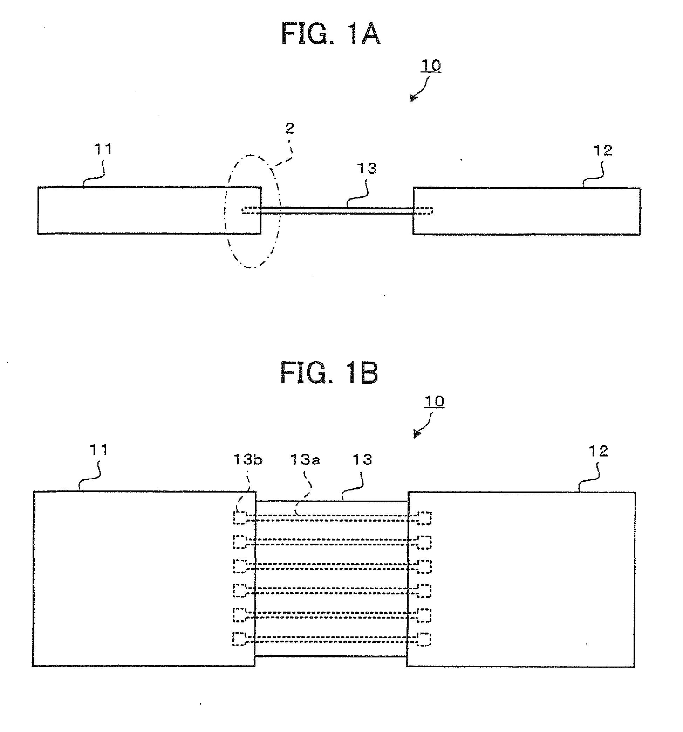

As shown in Figs. 1A and 1B, the flex-rigid wiring board 10 according to this embodiment includes a first rigid board (rigid board) 11, a second rigid board 12, and a flexible board 13 connecting the rigid boards 11 and 12 to each other.

On each of the first and second rigid boards 11 and 1 2, any desired circuit pattern is formed. If required, for example, an electronic component such as a semiconductor chip is connected to each board.

On the flexible board 13, stripe-shaped wiring 13a is formed for connecting the circuit patterns on the first and second rigid boards 11 and 12. The wiring 13a connects the circuit patterns on the rigid boards 11 and 12 to each other.

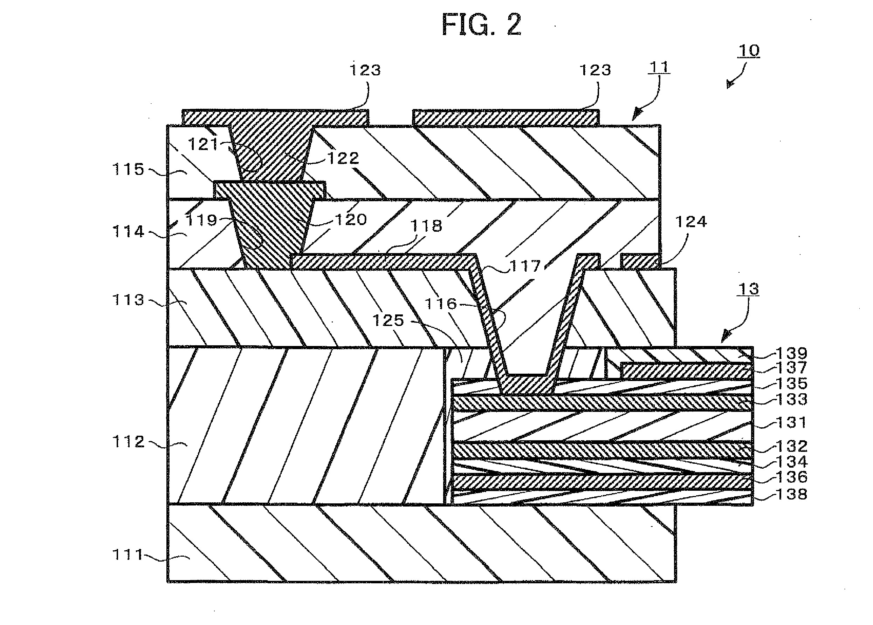

Next, with respect to the structure of the junction portions between the rigid boards 11 and 12 and the flexible board 13, the junction portion between the rigid board 11 and the flexible board 13 will be described as an example with reference to Fig. 2. Fig. 2 is an enlarged sectional view of an area denoted by reference numeral 2 in Fig. 1A.

As shown in the drawing, the flexible board 13 has a structure in which a substrate 131, conductor layers 132 and 133, insulating layers 134 and 135, shield layers 136 and 137, and cover lays 138 and 139 are laminated.

The substrate 131 is composed of an insulating flexible sheet, for example, a polyimide sheet having a thickness of 20 to 50 µm and preferably about 30 µm.

The conductor layers 132 and 133 are formed on the front and back surfaces of the substrate 131, respectively, and each have a wiring stripe pattern 13a. For example, each of the conductor layers 132 and 133 has a copper pattern having a thickness of about 5 to 15 µm.

The insulating layers 134 and 135 are composed of a polyimide film having a thickness of about 5 to 15 µm and insulate the conductor layers 132 and 133, respectively, from the outside.

The shield layers 136 and 137 are conductive layers each including, for example, a silver paste cured film and shield the conductor layers 132 and 133 from external electromagnetic noise and shield the emission of electromagnetic noise toward the outside.

The cover lays 138 and 139 include insulating films of polyimide or the like having a thickness of about 5 to 15 µm and insulate and protect the whole flexible board 13 form the outside.

On the other hand, the rigid board 11 includes a laminate of a first insulating layer 111, a non-flexible substrate 112, a second insulating layer 113, and first and second upper insulating layers 114 and 115.

The non-flexible substrate 112 gives rigidity to the rigid board 11 and is composed of a non-flexible insulating material such as a glass epoxy resin. The non-flexible substrate 112 is disposed with a space from the flexible board 13 in a horizontal direction. The non-flexible substrate 112 has substantially the same thickness as the flexible board 13, for example, 50 to 150 µm and preferably about 100 µm.

Each of the first and second insulating layers 111 and 113 is formed by curing prepreg and has a thickness of 50 to 100 µm and preferably about 50 µm.

The prepreg preferably contains a resin having a low flow characteristic. Such prepreg can be prepared by impregnating a glass cloth with an epoxy resin and then thermally curing the resin to increase the degree of curing.

The prepreg can also be formed by impregnating a glass cloth with a resin with high viscosity, impregnating a glass cloth with a resin containing an inorganic filler, e.g., a silica filler, or impregnating a glass cloth with a decreased amount of resin.

The first and second insulating layers 111 and 113 cover both the front and the back surfaces of the non-flexible, substrate 112 and the flexible board 13 to partially expose the flexible board 13. The resin of the first and second insulating layers 111 and 113 is polymerized with the resin of the cover lays 138 and 139 on the surfaces of the flexible board 13.

The non-flexible substrate 112 and the first and second insulating layers 111 and 113 constitute the core of the rigid board 11 to support the rigid board 11 and hold one of the ends of the flexible board 13 to support and fix the flexible board 13.

The spaces formed by the non-flexible substrate 112, the flexible board 13, and the first and second insulating layers 111 and 1113 are filled with a resin 125. The resin 125 seeps from the low-flow prepreg constituting the first and second insulating layer 111 and 113, for example, during manufacture. The resin 125 is cured integrally with the first and second insulating layers 111 and 113.

Furthermore, in the second insulating layer 113, vias (via holes or contact holes) 116 are formed in a portion opposing connection pads 13b of the wiring 133 of the flexible board 13.

In the flexible board 13, the shield layer 137 and the cover lay 139 of the flexible board 13 are removed from a portion opposing the vias 116 (a portion in which the connection pads 13b of the conductor layer 13a are formed). The vias 116 pass through the insulating layer 135 of the flexible board 13 to expose the connection pads 13b of the conductor layer 133.

In addition, a conductor layer 117 is formed on the inner surface of each of the vias 116 by copper plating or the like. The wiring pattern 117 is connected by plating to the connection pads 13b of the conductor layer 113 of the flexible board 13. The vias 116 are filled with a resin.

Furthermore, an extraction pattern 118 is formed on the second insulating layer 113 to be connected to the wiring pattern 117. The extraction pattern 118 includes a copper plating layer or the like.

Furthermore, a copper pattern 124 insulated from other components is formed at an end of the second insulating layer 113, i.e., at a position beyond the boundary between the flexible board 13 and the non-flexible substrate 112. Therefore, heat generated in the rigid board 11 can be effectively radiated.

The first upper insulating layer 114 is laminated on the second insulating layer 113. The first upper insulating layer 114 is formed by curing a material containing an inorganic material, for example, prepreg prepared by impregnating a glass cloth with a resin. This can improve the resistance to dropping impact. In the process of manufacturing the flex-rigid wiring board, the vias 116 are filled with the resin seeping from the prepreg.

Furthermore, the second upper insulating layer 115 is disposed on the first upper insulating layer 114. The second upper insulating layer 115 is also formed by curing prepreg including a glass cloth impregnated with a resin.

In the first upper insulating layer 114 disposed on the second insulating layer 113, vias (first upper vias) 119 are formed to be connected to the extraction pattern 118. The vias 119 are filled with a conductor 120 such as copper or the like. In the second upper insulating layer 115 laminated on the first upper insulating layer 114, vias (second upper via) 121 are formed to be connected to the vias 119. The vias 121 are filled with a conductor 121 such as copper or the like. Namely, the vias 119 and 121 form field built-up vias.

Furthermore, a conductor pattern (circuit pattern) 123 is appropriately formed on the second upper insulating layer 115. The vias 119 are appropriately connected to the conductor pattern 123.

The constitution of the connection portion between the rigid board 12 and the flexible board 13 is the same as that of the connection portion between the rigid board 11 and the flexible board 13.

In the flex-rigid wiring board 10 having the above constitution, the end of the flexible board 13 is held between the first and second insulating layers 111 and 113 which constitute the core portion of the rigid board 11 and subjected to resin polymerization.

Furthermore, the connection pads 13b of the conductor layer 133 of the flexible board 13 are connected to the conductor pattern 123 of the rigid board 11 through the wiring pattern (copper plating layer) 117 formed in the vias 116 which are formed in the second insulating layer 113 and the insulating layer 135.

Therefore, when the flexible board 13 is bent, stress applied to the flexible board 13 is not transmitted to the connection portion (the vias 116 and the wiring layer pattern 117) of the rigid board 11. Thus, stress applied to the connection portion between the rigid board 11 and the flexible board 13 is decreased to improve reliability.

The conductor layer 133 of the flexible board 13 is connected by plating to the wiring pattern 117 in the vias 116 of the rigid board 11. Therefore, the connection portion has high reliability.

The vias 116 are filled with the resin of the upper insulating layer 114. Since the vias 116 are fixed and supported by the resin in the vias 116, the connection reliability between the vias 116 and the conductor layer 133 is improved.

The end surfaces of the insulating layers 113 and 111 which face the flexible board 13 project beyond the end of the upper insulating layer 114 which faces the flexible board 13. Therefore, when the flexible board 13 is bent, stress applied to the flexible board 13 is not transmitted to the connection portion (the vias 116 and the wiring pattern 117) of the rigid board 11. Thus, stress applied to the connection portion between the rigid board 11 and the flexible board 13 is decreased to improve reliability.

The horizontal extension and contraction of the extensible flexible board 13 is suppressed by the core portion of the rigid board 11. Therefore, bending reliability and heat resistance reliability are high. Also, the flexible substrate portion of the flexible board 13 is exposed between the rigid boards 11 and 12, and thus bending stress applied to wiring is small as compared with a case in which the whole is covered with an insulating resin or the like.

In the flex-rigid wiring board 10, the end portion of the flexible board 13 is held between the first and second insulating layers 111 and 113 of the rigid board 11. Therefore, a change in dimensions of the flexible board 13 has small influence, and a positional error of the connection lands (the vias 116) of the rigid board 11 can be deceased. Thus, the vias 116 having a smaller diameter can be designed.

The flexible board 13 is not disposed in the rigid boards 11 and 12. Therefore, the same degree of reliability as that of a general rigid board can be maintained. In addition, a general-purpose plating solution can be used because of the high resistance to a plating solution. Similarly, since a flex material is not used in a rigid portion, the same heat resistance as a usual rigid portion can be maintained.

Furthermore, the flexible board 13 is partially used and effectively disposed, thereby suppressing the manufacturing cost.

Each of the upper insulating layers 114 and 115 is formed from usual prepreg. Usual prepreg is excellent in compatibility between inner layer patterns, and thus insulation deterioration due to the occurrence of voids or the like can be avoided. In addition, a fine pattern, for example, a pattern with L/S of 60/50 or 50/50 µm, can be realized. This can be achieved with a limitation on material control.

Furthermore, a general-purpose interlayer material (prepreg) is used as each of the upper insulating layers 114 and 115. Therefore, in the manufacturing process, IVH (Interstitial Via Hole) including the vias 116 can be filled with the resin constituting the upper insulating layers 114 and 115. Thus, a resin exclusively used for filling in holes need not be used.

Since a glass epoxy substrate is used as the core portion of each of the rigid boards 11 and 12, dropping impact resistance can be improved.

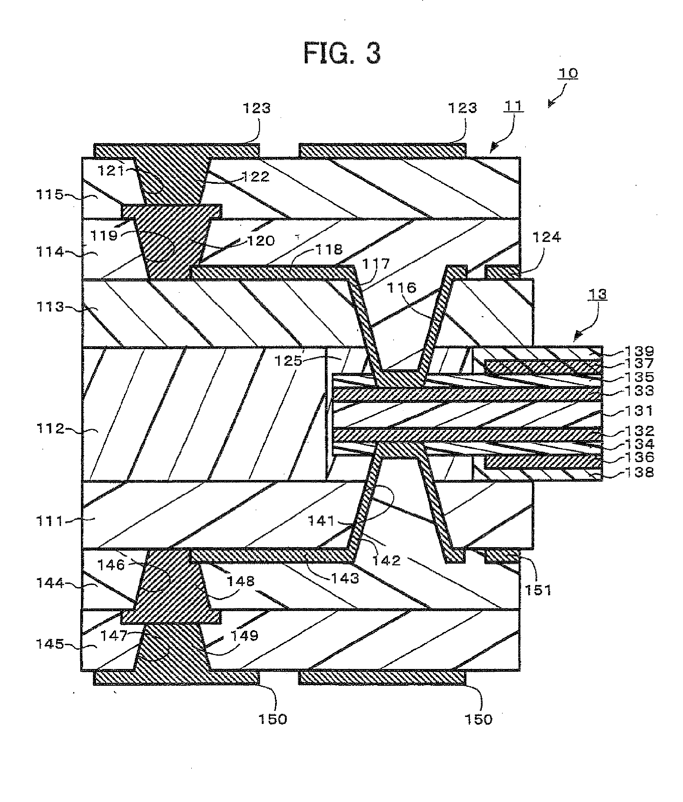

In this embodiment, a conductor pattern is formed only on the upper surface of each of the rigid boards 11 and 12 for sake of easy understanding. The present invention is not limited to this. For example, as shown in Fig. 3, a conductor pattern may be formed on the lower surface of each of the rigid boards 11 and 12.

In the constitution shown in Fig. 3, vias 141 are formed in the first insulating layer 111 and the insulating layer 134 of the flexible board 13. In each via 141, a wiring pattern 142 is formed and connected to an extraction pattern 143 formed on the first insulating layer 111. The wiring pattern 142 and the extraction pattern 143 are formed by patterning a copper plating layer.

Furthermore, third and fourth upper insulating layers 144 and 145 are laminated on the first insulating layer 111. Vias 146 and 147 are formed in the third and fourth upper insulating layers 144 and 145, respectively. The vias 146 and 147 are filled with conductors 148 and 149, respectively. A conductor pattern 150 is formed on the fourth upper insulating layer 145.

Next, a method of manufacturing the flex-rigid wiring board 10 having the above-descried construction will be described.

First, a method for manufacturing the flexible board 13 will be described.

Copper films are formed on both surfaces of the polyimide substrate 131 processed into a predetermined size. Next, the copper films are patterned to form the conductor layers 132 and 133 each having the wiring pattern 13a and the connection pads 13b.

The insulating films 134 and 135 each including a polyimide layer are formed on the polyimide substrate 131 and the conductor layers 132 and 133, respectively. Furthermore, silver paste is applied except on the end of the flexible board 13, and the applied silver paste is cured to form the shield layers 136 and 137.

Then, the cover lays 138 and 139 are formed to cover the shield layers 136 and 137 on the front and the back surfaces, respectively.

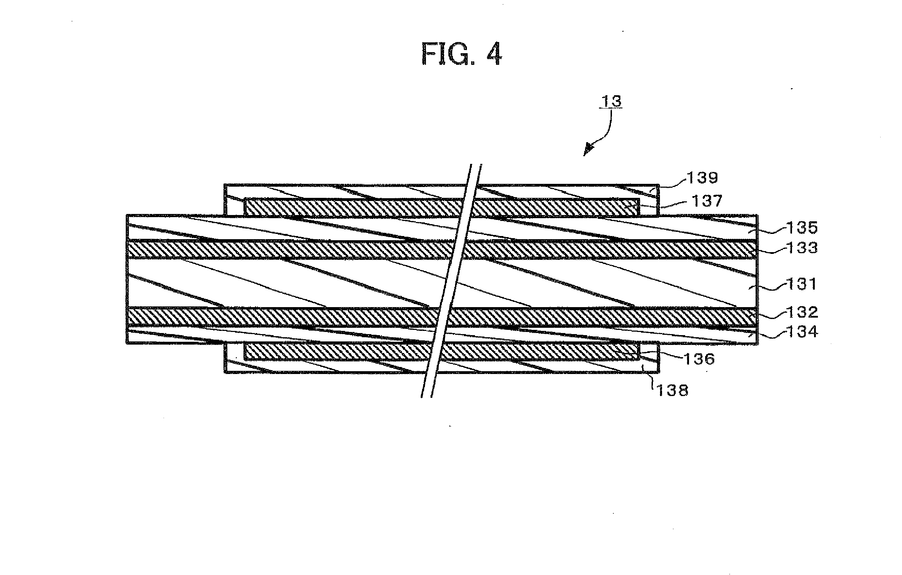

As a result, the flexible board 13 having the constitution shown in Fig. 4 is completed. The shield layers 136 and 137 and the cover lays 138 and 139 are formed avoiding the connection pads 13b.

Next, a method of bonding the rigid boards 11 and 12 and the flexible board 13 together will be described.

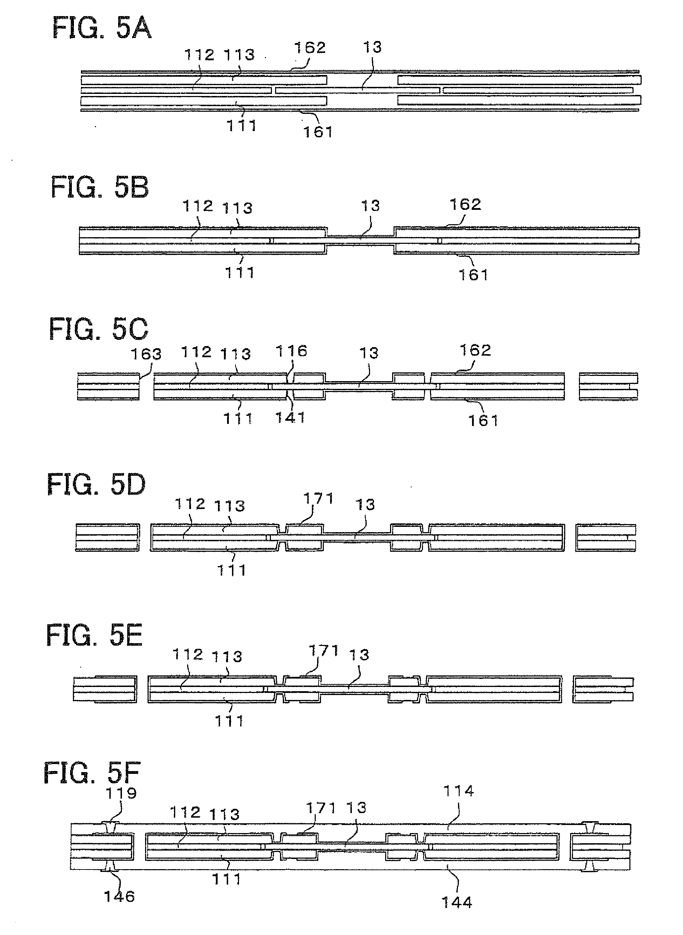

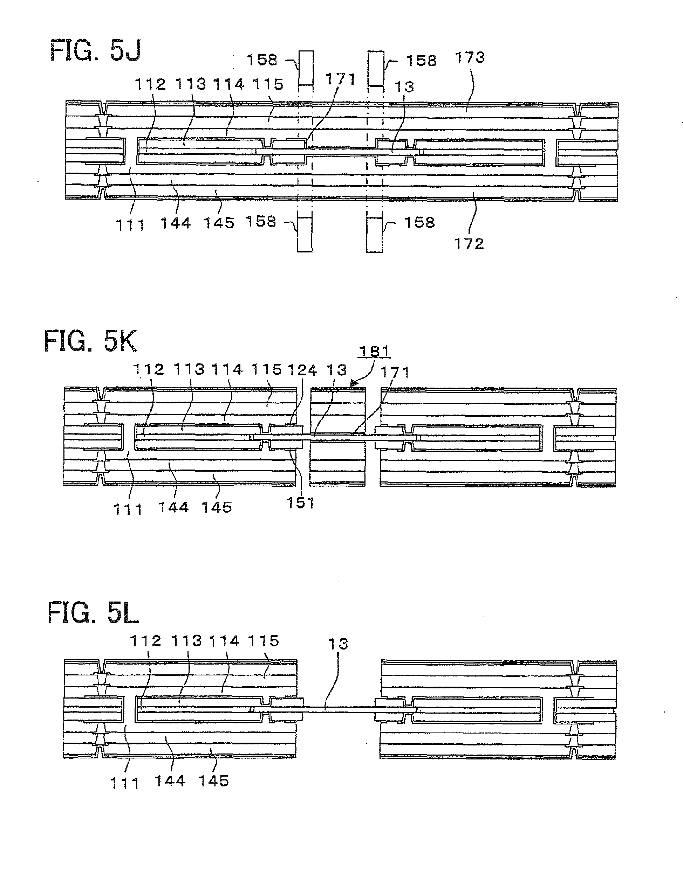

First, as shown in Fig. 5A, the first insulating film 111, the non-flexible substrate 112, and the second insulating layer 113, which constitute the core of the rigid board 11, are aligned. Each of the first and second insulating layers 111 and 113 includes, for example, a prepreg having a thickness of 20 to 50 µm, and the non-flexible substrate 112 includes, for example, a glass epoxy substrate having a thickness of about 100 µm.

As shown in Fig. 2, the thickness of the non-flexible substrate 112 is preferably substantially the same as the thickness of the flexible board 13. In this case, the space between the non-flexible substrate 112 and the cover lay 139 is filled with the resin 125, and thus the flexible board 13 and the son-flexible substrate 112 can be securely bonded together.

The resin 125 filled in the space is cured integrally with the insulating layer 113 to fix the peripheries of the vias 116 with the resin 125, thereby improving the reliability of connection between the vias 116 and the conductor layer 133.

Similarly, the non-flexible substrate and the first and second insulating layers constituting the core portion of the rigid board 12 are aligned.

Furthermore, one of the ends of the flexible board 13 is inserted between the first and second insulating layers 111 and 113 of the rigid board 11 and aligned, and the other end is disposed between the first and second insulating layers and the non-flexible substrate of the rigid board 12. Furthermore, conductor films 161 and 162 are disposed on and below these layers.

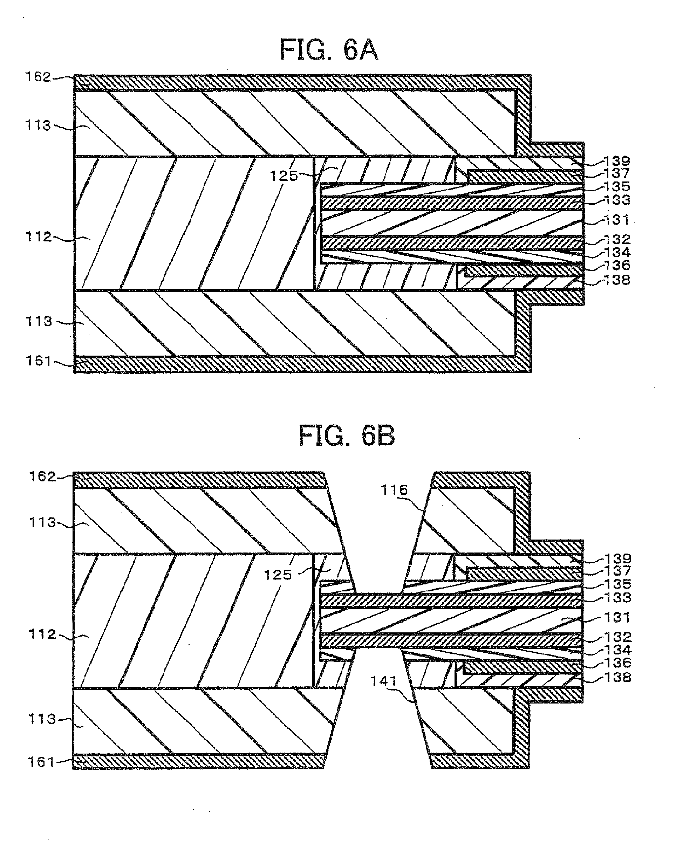

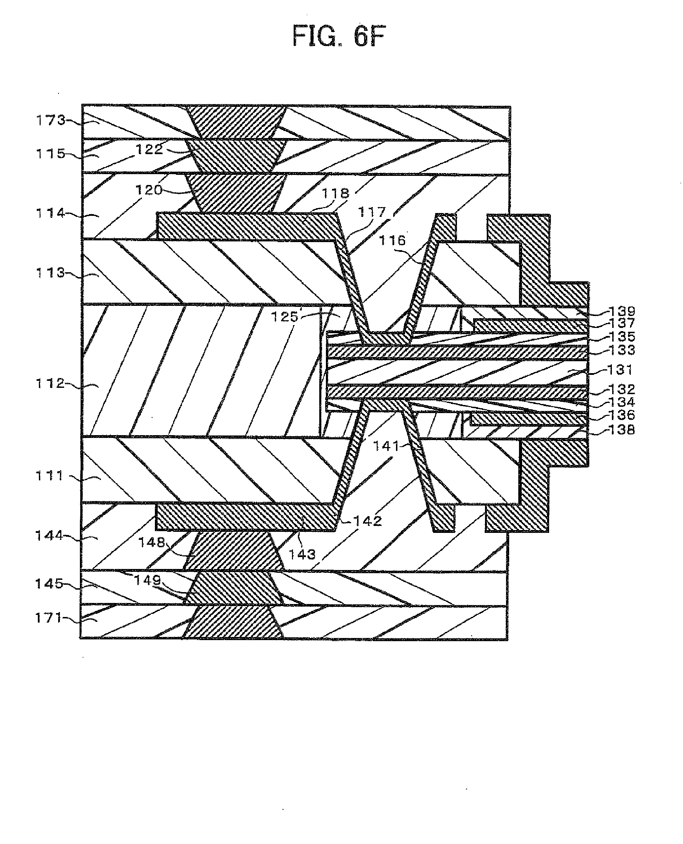

Next, as shown in Fig. 5B, these layers are pressed under pressure. At this time, as shown in an enlarged view of Fig. 6A., the spaces between the non-flexible substrate 112 and the flexible board 13 are filled with the resin 125 extruded from the prepreg constituting each of the first and second insulating layers 111 and 113. Since the spaces are filled with the resin 125, the flexible board 13 and the non-flexible substrate 112 can be securely bonded together.

The pressure pressing is performed, for example, using a hydropress apparatus at a temperature of 200°C and a pressure of 40 kgf for a pressure time of about 3 hours.

Then, the whole is heated to cure the prepreg constituting each of the first and second insulating layers 111 and 113 and the resin 125 to integrate the resins. At the same time, the resin of the cover lays 138 and 139 of the flexible board 13 and the resin of the first and second insulating layers 111 and 113 are polymerized. The resin of the insulating layers 111 and 113 is polymerized to fix the peripheries of the vias 116 with the resin, thereby improving the reliability of connection between the vias 116 and the conductor layer 133.

Next, as shown in Fig. 5C, IVH (interstitial Via Hole) 163 is formed by irradiation of CO₂ laser from a CO₂ laser processing apparatus according to demand. At the same time, as shown in an enlarged view of Fig. 6B, the vias 116 and 141 are formed for connecting the wiring layers 132 and 133 of the flexible board 13 to the rigid boards I 1 and 12.

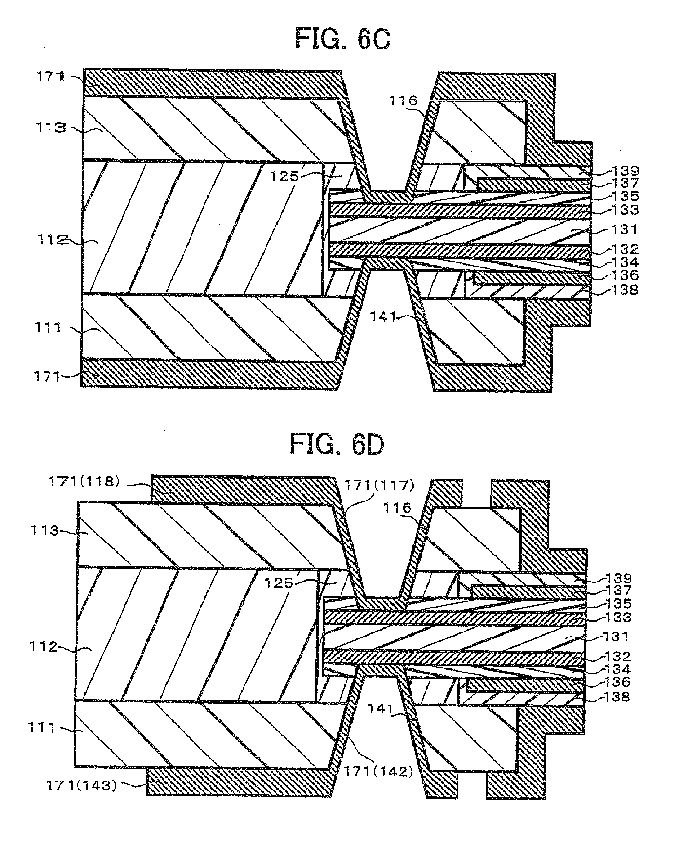

Then, as shown in Fig. 5D, copper plating is conducted on the surfaces of the whole structure. The copper plating layers and the copper patterns 161 and 162 previously formed are integrated to form a copper film 171 over the entire surface of the board. As shown in Fig. 6C, the copper film 17 is formed in the vias 116 and 141. In the copper plating, the flexible board 13 is covered with the copper foils 161 and 162 without making direct contact with a plating solution. Therefore, the flexible board 13 is not damaged by the plating solution.

Then, as shown in Fig. 5E, the copper film 171 on the surface of the board is patterned. In this step, the wiring patters 117 and 142 connected to the conductor layers 132 and 133 of the flexible board 13 and the extraction patterns 118 and 143 are formed.
At the same time, as shown in Fig. 6D, the copper film 171 is left on the end portions of the first and second insulating layers 111 and 113.

Then, as shown in Fig. 5F, the first and third upper insulating layers 114 and 144 are disposed on and below the resulting structure. Each of the first and third upper insulating layers 114 and 144 includes, for example, a prepreg prepared by impregnating a glass cloth with a resin. The vias 116 and 141 are filled with the resin from the prepreg.

Then, the resin in the prepreg and the vias is cured by heating to fix the first and third upper insulating layers 114 and 144. Next, the vias 119 and 144 are formed in the first and third upper insulating layers 114 and 144, respectively, and filled with a conductor by copper plating or the like. The vias 119 and 114 may be filled with conductive paste (e.g., thermosetting resin containing conductive particles) by printing such as screen printing and then subjected to resin curing.

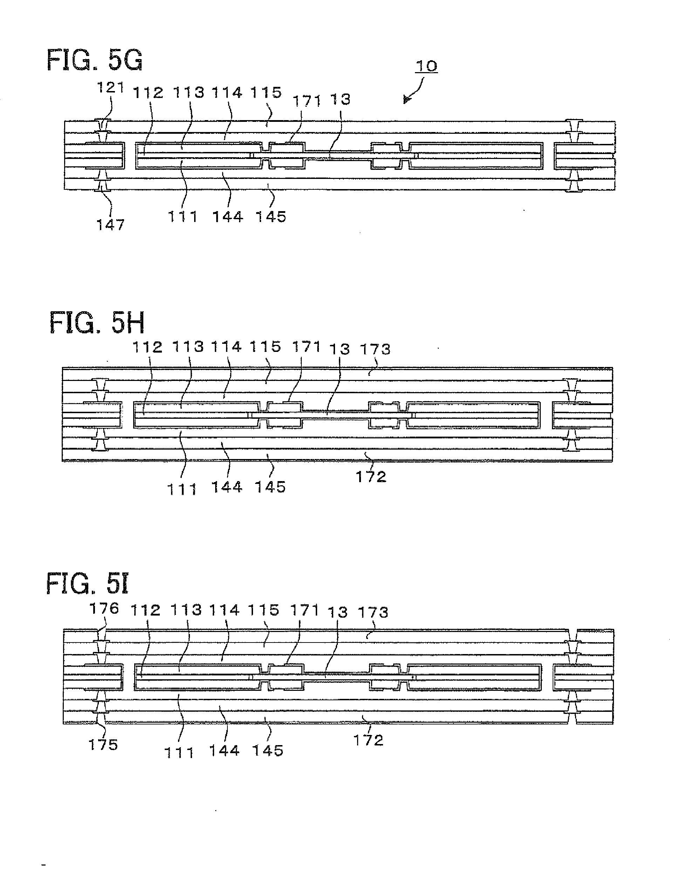

Then, as shown in Fig. 5G, the second and fourth upper insulating layers 115 and 145 are disposed on and bellow the whole board. Each of the second and fourth upper insulating layers 115 and 145 includes, for example, usual prepreg prepared by impregnating a glass cloth with a resin.

Next, the resin of the prepreg is cured by heating to fix the second and fourth upper insulating layers 115 and 145.

Furthermore, the vias 121 and 147 are formed in the second and fourth upper insulating layers 115 and 145, respectively, and filled with a conductor by copper plating. The vias 121 and 147 may be filled with conductive paste (e.g., thermosetting resin containing conductive particles) by printing such as screen printing and then subjected to resin curing. When the vias 121 and 147 are filled with the same conductive paste material, with the thermal stress applied, connection reliability of the vias 221 and 147 can be improved.

If required, as shown in Fig. 5H, copper foil sheets with resin (resin copper film: RCF) 172 and 173 are disposed on the outermost layers of the board.

Then, the whole is heated to cure the resin.

Next, as shown in Fig. 5I, vias 174 and 175 are formed in the RCFs 172 and 173, respectively. Next, the vias 174 and 175 are filled with a conductor by copper plating. If required, the surface copper foils are patterned to form conductor patterns.

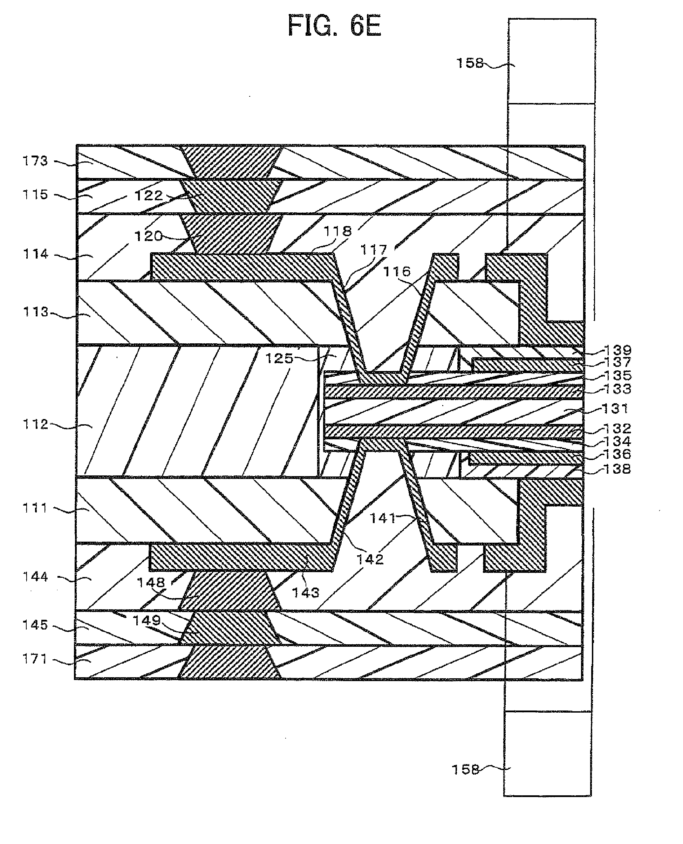

Next, as shown in Figs. 5J and 6E, the joint portions between the rigid boards 11 and 12 and the flexible board 13 are irradiated with laser beam 158, for example, CO₂ laser, from a laser processing apparatus, using as a stopper the copper foil 171 formed at the ends of the cores of rigid boards 11 aid 12 to cut the upper insulating layers 114, 115, 144, and 145, and the copper foil sheets with resin (RCFs) 172 and 173. In this step, the energy or irradiation time is controlled so as to cut the copper foil 171 used as a stopper to some extent.

As a result, as shown in Fig. 5H, a structure 181 on the flexible board 13 is separated from the other portions.

Then, as shown in Fig. 5L, the structure 181 is removed from the flexible board 13 by peeling. The copper foils 161 and 162 (refer to Fig. 5B), which are a base of the remaining copper foil 171, are only pressed by the cover lays 138 and 139 of the flexible board 13 and is not fixed. Similarly, the copper foil 171 is not fixed to the flexible board 13. Therefore, the copper foil 171 is also removed by removal of the structure 181.

Consequently, the copper foil 171 is removed from portions not covered with the other members. Therefore, the copper foils 124 and 151 are left on portions covered with the prepregs 113 and 144 at the ends of the first and second insulating layers 111 and 113.

As a result, the flex-rigid wiring board 10 is completed, in which the ends of the flexible board 13 are held between the core portions (the first and second insulating layers 111 and 113) of the rigid boards 11 and 12, and the lands of the rigid boards 11 and 12 are connected to the connection pads of the flexible board by plating.

In the above-described constitution, plating on the polyimide of the flexible board 13 is not required, hereby securing connection reliability.
In addition, RCF can be used on the outermost layers of the rigid boards 11 and 12. Therefore, the same reliability and dropping resistance as those of a usual rigid board can be secured.

In the manufacturing method, prepreg including a resin having a low flow property is required for forming the core layer of each of the rigid boards 11 and 13. However, usual prepreg can be used for layers other than the core layers, and thus IVH filling is not required, thereby little producing voids.

Furthermore, only a bending portion includes a flexible board, and thus stability is improved.

Furthermore, holes are formed in a plurality of layers by laser processing after the formation of outer layers, and thus the manufacturing cost can be suppressed.

Since holes are formed in a plurality of layers by laser processing after the formation of outer layers, opening accuracy of the flexible board is increased.

Since a glass epoxy substrate is used for the core portions of the rigid boards 11 and 12, dropping impact resistance can be improved.

Although the flex-rigid wiring board 10 according to an embodiment of the present invention, is descried above, the present invention is not limited to this embodiment.

For example, the materials, sizes, and number of the layers may be appropriately changed.

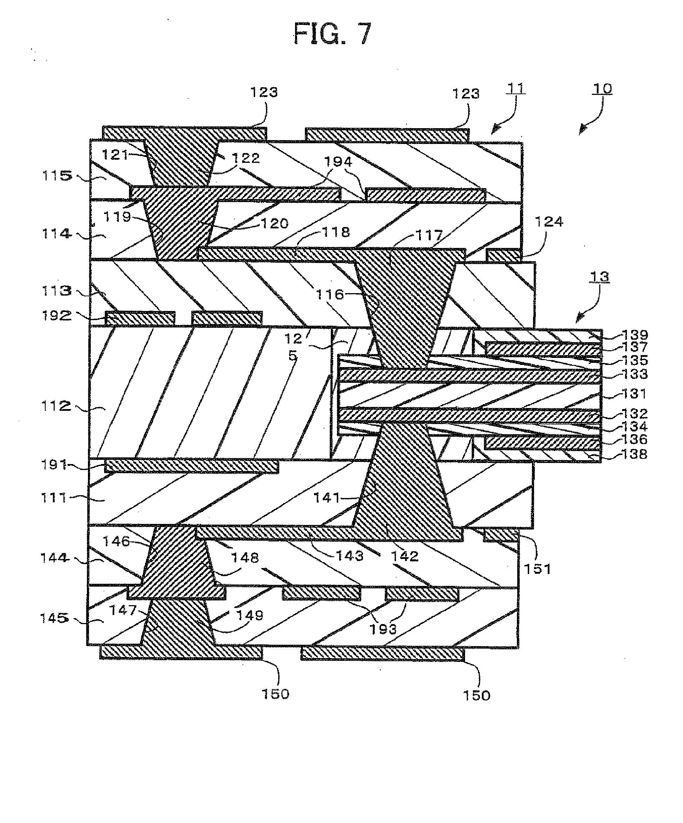

As illustrated in Fig. 7, the vias 116 and 141 may be filled with a conductor such as a plating metal. When the vias 116 and 141 are not completely filled with the resin, voids are present in the vias 116 and 141. In this case, when heat is applied to the flex-rigid wiring board 10, the connection reliability of the vias may be degraded due to the expansion of the voids. When the vias 116 and 141 are filled with a plating metal as shown in Fig. 7, with the heat applied, the connection reliability of the vias 116 and 141 can be improved.

Similarly, conductor patterns (circuit patterns) 191 and 192 may be formed on the non-flexible substrate 112, for connection with any desired portion.

Also, conductor patterns (circuit patterns) 193 and 194 may be formed on the first and third upper insulating layers 114 and 144, for connection with any desired portion.

The conductor patterns 191, 143, 193, and 150 are connected to each other through the vias 146 and 147 and any other vias. Similarly, the conductor patterns 192, 118,194, and 123 are connected to each other through the vias 119 and 121 and other vias. Furthermore, the conductor patterns 123 and 150 are connected to each other through the vias 163.

The first and second insulating layers 111 and 113 which hold the end of the flexible board 23 therebetween may be composed of RCF. Each of the first and third upper insulating layers 114 and 144 and the second and fourth upper insulating layers 115 and 145 may be composed of RCF. In this constitution, a manufacturing step can be omitted.

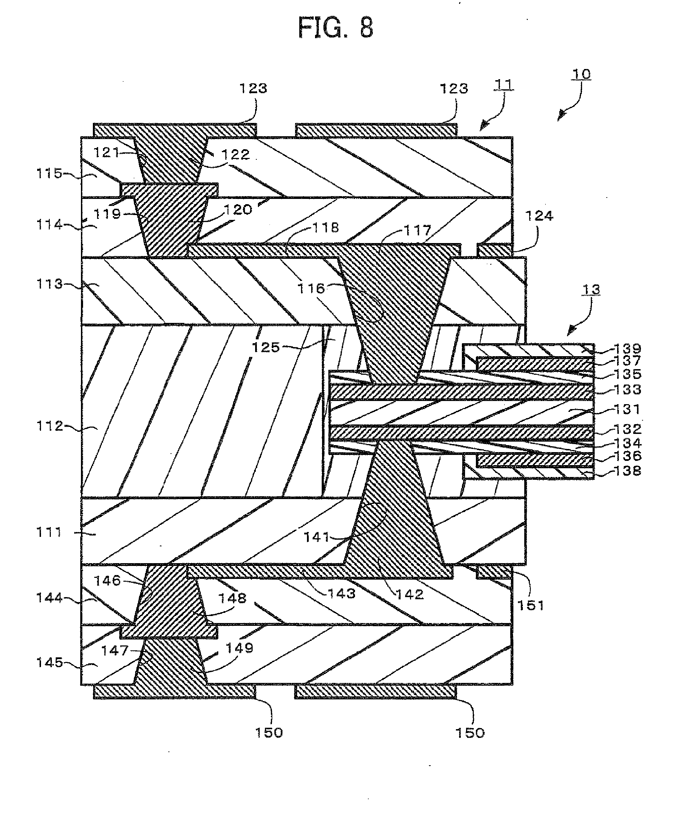

Although, in this embodiment, the flexible board 13 and the non-flexible substrate 112 have substantially the same thickness, the present invention is not limited to this. For example, as shown in Fig. 8, the flexible board 13 may be thinner than the non-flexible substrate 112. In this case, the spaces between the flexible board 13, the non-flexible substrate 112, and the first and second insulating layers 111 and 113 are filled with any resin, for example, the resin seeping from the insulating layers 111 and 113 or a resin previously inserted for adjusting the height during manufacture. In this way, the spaces are filled with the resin 125, and thus the flexible board 13 and the non-flexible substrate 112 can be securely bonded together.

The resin is integrally cured and fixed by heating during manufacture. Since the resins of the insulating layers 111 and 113 are polymerized, and the resin 125 is integrally cured and fixed, the peripheries of the vias 116 and 141 are fixed with the resin to improve the reliability of connection between the vias 116 and 141 and the conductor layers 133 and 132, respectively.

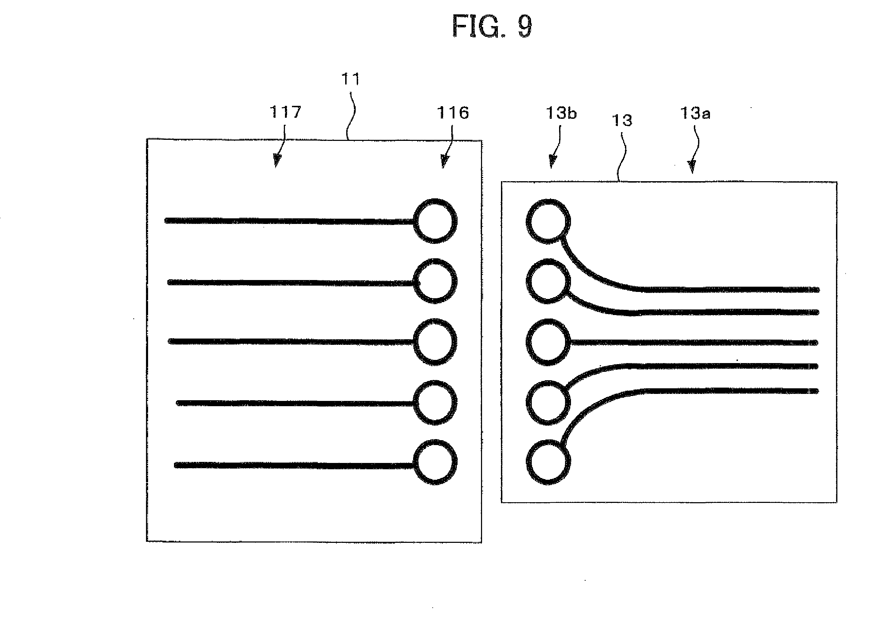

In addition, the wiring patterns formed on the rigid boards 11 and 12 and the flexible board 13 are not limited to the example shown in Fig. 1. For example, as illustrated in Fig. 9, the wiring patterns may be formed in a shape which fans out from the flexible board 13 toward the rigid boards 11 and 12. Namely, the pitch of wiring 13a of the flexible board 13 may be smaller than that on the connection portion 13b. In this case, many wirings can be disposed on the flexible board 13, and thus a flex-rigid wiring board having high-density wiring can be formed.

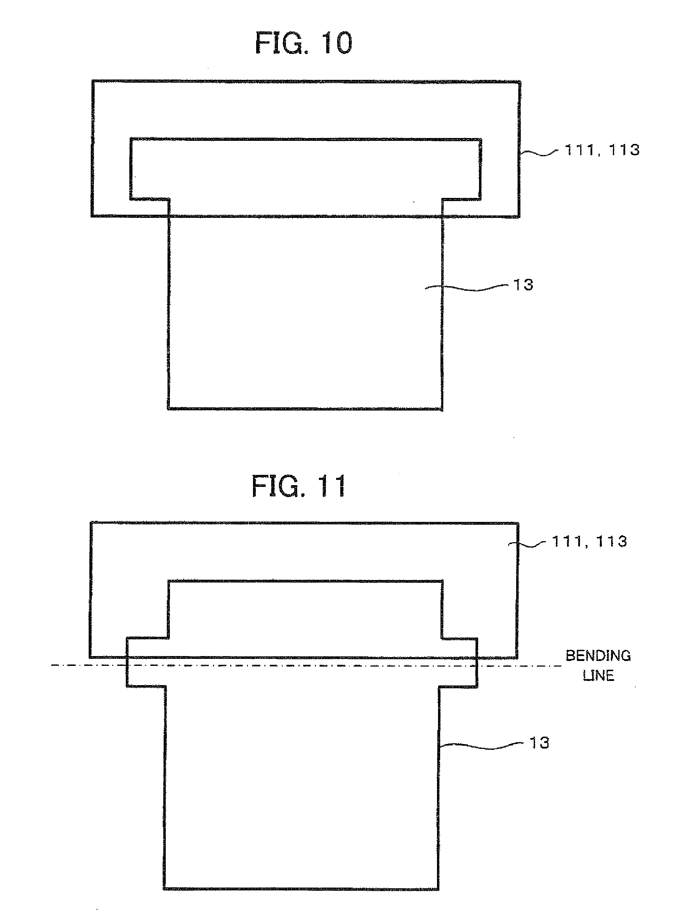

In order to increase the strength of the boundary portions between the rigid boards 11 and 12 and the flexible board 13, as illustrated in Figs. 10 and 11, it is effective to partially widen the flexible board 13. In this case, the area of connection between the flexible board 13 and the rigid boards 11 and 12 is increased, thereby improving the connection reliability of vias.

In an example shown in Fig. 10, an end of the flexible board 13 is widened to increase the area of a portion to be fixed to each of the rigid boards 11 and 12. In this case, the strength of the ends of the flexible board 13 can be increased to improve bending resistance.

In an example shown in Fig. 11, projections are formed at a position where bending of the flexible board 13 is repeated (for example, the position facing the end surfaces of the rigid boards 11 and 12) to increase the strength of the position where bending is repeated.

### Industrial Applicability

This invention is applicable to a flexible rigid wiring board including a non-flexible substrate portion and a flexible substrate portion.

The following numbered paragraphs provide further disclosure of the present invention:
1. A flex-rigid wiring board comprising:
   a flexible substrate having a conductor pattern;
   a non-flexible substrate disposed adjacent to the flexible substrate in the horizontal direction; an insulating layer covering the flexible substrate and the non-flexible substrate to expose at least a portion of the flexible substrate; and a conductor pattern formed on the insulating layer; wherein the conductor pattern of the flexible substrate is connected by plating to the conductor pattern on the insulating layer.
2. The flex-rigid wiring board according to paragraph 1, wherein the flexible substrate and the non-flexible substrate are disposed with a space therebetween, and the space is filled with a resin.
3. The flex-rigid wiring board according to paragraph 1, wherein the flexible substrate and the non-flexible substrate are disposed with a space therebetween, the space is filled with a resin, and the resin is cured integrally with the insulating layer.
4. The flex-rigid wiring board according to paragraph 1, further comprising a conductor pattern formed on the surface of the non-flexible substrate.
5. The flex-rigid wiring board according to paragraph 1, wherein the insulating layer covers both the front and back surfaces of the boundary region between the ends of the flexible substrate and the non-flexible substrate.
6. The flex-rigid wiring board according to paragraph 1, wherein the insulating layer covers both the front and back surfaces of the boundary region between the ends of the flexible substrate and the non-flexible substrate, a via is formed in the insulating layer, and the conductor pattern on the insulating layer is connected to the conductor pattern on the non-flexible substrate through the via.
7. The flex-rigid wiring board according to paragraph 1, further comprising: an upper insulating layer formed on the insulating layer; and an upper layer conductor pattern formed on the upper insulating layer; wherein the conductor pattern on the insulating layer is connected to the upper layer conductor pattern through an upper layer via filled with a plating metal, and the upper insulating layer includes a cured resin layer containing an inorganic material.
8. The flex-rigid wiring board according to paragraph 1, further comprising: a first upper insulating layer formed on the insulating layer; a first upper conductor pattern formed on the first upper insulating layer; a second upper insulating layer formed on the first upper conductor pattern; and a second upper conductor pattern formed on the second upper insulating layer; wherein the conductor pattern on the insulating layer is connected to the first upper conductor layer through a first upper via filled with a plating metal; and the first and second upper conductor patterns are connected through a second upper via filled with a plating metal and formed in a portion substantially directly above the first upper via of the second upper insulating layer.
9. The flex-rigid wiring board according to paragraph 1, further comprising: an upper insulating layer formed on the insulating layer; an upper layer via formed in the upper insulating layer and connected to the conductor pattern on the insulating layer; and a conductor pattern formed on the upper insulating layer and connected to the upper layer via.
10. The flex-rigid wiring board according to paragraph 1, wherein the upper insulating layer includes a glass cloth.
11. The flex-rigid wiring board according to paragraph 1, further comprising a copper foil sheet with resin laminated on the insulating layer, the copper foil sheet with resin being cured.
12. A flex-rigid wiring board comprising: a flexible substrate having a conductor pattern and a protective layer covering the conductor pattern; a non-flexible substrate disposed adjacent to the flexible substrate in the horizontal direction; an insulating layer covering the flexible substrate and the non-flexible substrate to expose at least a portion of the flexible substrate; and a conductor pattern formed on the insulating layer; wherein the conductor pattern on the flexible substrate is connected by plating to the conductor pattern on the insulating layer through a via formed in the insulating layer.
13. The flex-rigid wiring board according to paragraph 12, wherein an insulating layer is formed between the conductor pattern and the protective layer, the via is formed to pass through the insulating layer, the protective layer is provided in a region without the via, and a space between the non-flexible substrate and the protective layer and in the periphery of the via is filled with a resin.
14. The flex-rigid wiring board according to paragraph 12, wherein the protective layer is provided in a region without the via, the flexible substrate including the protective layer is thinner than the non-flexible substrate, and a space between the protective layer and the insulating layer and in the periphery of the via is filled with a resin, the resin being cured integrally with the insulating layer.
15. The flex-rigid wiring board according to paragraph 12, wherein the flexible substrate includes a conductor pattern and at least one protective layer covering the conductor pattern, the thickness of the flexible substrate including the protective layer is substantially the same as that of the non-flexible substrate, the protective layer is provided in a region without the via, and a space between the non-flexible substrate and the protective layer and in the periphery of the via is filled with a resin.
16. The flex-rigid wiring board according to paragraph 12, wherein the flexible substrate includes a conductor pattern and a protective layer covering the conductor pattern, the thickness of the flexible substrate including the protective layer is substantially the same as that of the non-flexible substrate, the protective layer is provided in a region without the via, and a space between the non-flexible substrate and the protective layer and in the periphery of the via is filled with a resin, the resin being cured integrally with the insulating layer.
17. The flex-rigid wiring board according to paragraph 12, wherein the flexible substrate is thinner than the non-flexible substrate.
18. The flex-rigid wiring board according to paragraph 12, wherein in the flexible substrate, a portion where the resins of the flexible substrate and the insulating layer are polymerized is wider than a portion where the resins are not polymerized.
19. The flex-rigid wiring board according to paragraph 12, wherein in the flexible substrate, the boundary portion between the flexible substrate and the insulating layer is wider than other portions.
20. The flex-rigid wiring board according to paragraph 12, wherein the protective layer includes an insulating film, and a via is formed in the insulating layer and the insulating film to pass through them, for electrically connecting the conductor pattern on the insulating layer to the conductor pattern formed on the flexible substrate.
21. The flex-rigid wiring board according to paragraph 12, wherein the protective layer of the flexible substrate includes a shield layer against an electromagnetic wave.
22. The flex-rigid wiring board according to paragraph 12, further comprising: a conductor pattern formed on the flexible substrate; an insulating film formed on the conductor pattern; and an electromagnetic shield layer formed on the insulating film.
23. The flex-rigid wiring board according to paragraph 12, further comprising: a conductor pattern formed on the flexible substrate; an insulating film formed on the conductor pattern; an electromagnetic shield layer formed on the insulating film; and a protective layer formed on the electromagnetic shield layer.
24. The flex-rigid wiring board according to paragraph 12, further comprising: a conductor pattern formed on the flexible substrate; an insulating film formed on the conductor pattern; an electromagnetic shield layer formed on the insulating film; and a protective layer formed on the electromagnetic shield layer to make contact with the insulating layer.
25. A method of manufacturing a flex-rigid wiring board comprising: disposing a flexible substrate having a conductor pattern and a non-flexible substrate adjacent to each other; covering the boundary between the flexible substrate and the non-flexible substrate with an insulating layer having a conductor pattern; forming a via which passes through the insulating layer and reaches the conductor pattern of the flexible substrate; and connecting by plating the conductor pattern of the flexible substrate to the conductor pattern on the insulating layer through the via.
26. The method according to paragraph 25, wherein the insulating layer contains a resin, a space between the non-flexible substrate, the flexible substrate, and the insulating layer is filled with the resin of the insulating layer, and the filled resin is cured integrally with the insulating layer.
27. The method according to paragraph 25, wherein the via is filled with a plating metal by the plating.
28. The method according to paragraph 25, wherein the insulating layer covers the front and back surfaces of the boundary between the flexible substrate and the non-flexible substrate.
29. The method according to paragraph 25, further comprising:
   disposing a metal foil on the insulating layer and the flexible substrate; disposing a second insulating layer on the metal foil; and cutting the second insulating layer at a position corresponding to the end of the insulating layer by the laser using the metal foil as a stopper.
30. The method according to paragraph 25, further comprising:
   disposing a metal foil on the insulating layer and the flexible substrate; disposing a second insulating layer on the metal foil; cutting the second insulating layer at a position corresponding to the end of the insulating layer by the laser using the metal foil as a stopper; and removing a portion remaining on the flexible substrate after the laser cutting together with the metal foil.
31. The method according to paragraph 25, further comprising:
   disposing a metal foil on the insulating layer and the flexible substrate; patterning the metal foil to form a circuit pattern on the insulating layer; disposing a second insulating layer on the metal foil; and cutting the second insulating layer by the laser at a position corresponding to the end of the insulating layer using the metal foil as a stopper.
32. The method according to paragraph 25, further comprising:
   disposing a metal foil on the insulating layer and the flexible substrate; disposing a second insulating layer on the metal foil; forming a conductor pattern on the second insulating layer; and cutting the second insulating layer by the laser at a position corresponding to the end of the insulating layer using the metal foil as a stopper.
33. The method according to paragraph 25, wherein the second insulating layer contains a resin, and the via is filled with the resin of the second insulating layer.

## Claims

1. A flex-rigid wiring board comprising:
a flexible substrate having a conductor pattern;
a non-flexible substrate disposed adjacent to the flexible substrate in the horizontal direction; and
an insulating layer covering the flexible substrate and the non-flexible substrate to expose at least a portion of the flexible substrate;
wherein a via is formed in the insulating layer,
a conductor pattern is formed on the insulating layer,
and the conductor pattern on the insulating layer is connected to the conductor pattern on the flexible substrate through the via.

2. The flex-rigid wiring board according to claim 1, further comprising:
an upper insulating layer formed on the insulating layer; and
an upper layer conductor pattern formed on the upper insulating layer;
wherein the conductor pattern on the insulating layer is connected to the upper layer conductor pattern through an upper layer via formed in the upper insulating layer and filled with a plating metal.

3. The flex-rigid wiring board according to claim 1, further comprising
a resin layer containing a resin and disposed on the insulating layer, wherein the via is filled with the resin of the resin layer.

4. The flex-rigid wiring board according to claim 1,
wherein the via is filled with a metal.

5. The flex-rigid wiring board according to claim 1,
wherein the via passes through the insulating layer and is filled with a plating metal,
an upper insulating layer and an upper conductor pattern are laminated on the insulating layer,
the conductor pattern formed on the insulating layer is connected to the upper conductor pattern through an upper layer via formed in the upper insulating layer,
and the upper layer via is connected to the via filled with the plating metal.

6. The flex-rigid wiring board according to claim 1,
wherein the conductor pattern on the insulating layer extends to the end of the insulating layer beyond the boundary between the flexible substrate and the non-flexible substrate.

7. The flex-rigid wiring board according to claim 1, further comprising
a planar conductor layer formed at the end of the insulating layer on the side facing the flexible substrate.

8. The flex-rigid wiring board according to claim 1,
wherein the flexible substrate has a plurality of connection pads to be connected to vias,
the pitch of the connection pads is larger than the pitch of a plurality of conductor patterns formed on the flexible substrate,
and the conductor patterns are formed so that the pitch increases toward the connection pads and electrically connected to the corresponding connection pads.

9. The flex-rigid wiring board according to claim 1, further comprising:
an upper insulating layer formed on the insulating layer; and
an upper layer conductor pattern formed on the upper insulating layer;
wherein the conductor pattern on the insulating layer is connected to the upper layer conductor pattern through an upper layer via formed in the upper insulating layer; and
the end of the insulating layer, which faces the flexible substrate, projects beyond the end of the upper insulating layer, which faces the flexible substrate.

10. The flex-rigid wiring board according to claim 1, further comprising:
an upper insulating layer formed on the insulating layer; and
an upper layer conductor pattern formed on the upper insulating layer;
wherein the conductor pattern on the insulating layer is connected to the upper layer conductor pattern through an upper layer via formed in the upper insulating layer; and
the upper layer via is filled with a cured product of a conductive paste.
